# EUROPEAN PATENT APPLICATION

(11) **EP 1 585 076 A1**
(43) Date of publication of application: **12.10.2005**
(21) Application number: 05251471.8
(22) Date of filing: 11.03.2005
(51) Int. Cl.: G08B 13/24, B32B 15/08

(54) **A method of manufacturing laminated material for security tags**

(30) Priority: 31.03.2004 JP 2004101731
(71) Applicant: TOKAI ALUMINUM FOIL CO., LTD., Kanagawa-ken (JP)
(72) Inventor: Yamada, Kazunori, Atsugi-shi Kanagawa-ken (JP); Ushino, Shun-ichi, Chigasaki-shi Kanagawa-ken (JP); Katagiri, Kaoru, Kanagawa-ken (JP); Sasaki, Shogo, Kanagawa-ken (JP)
(74) Representative: Calderbank, Thomas Roger

(57) **Abstract**

A laminated material suitable for fabricating miniaturized security tags which have the uniform resonance frequency, and security tags obtained by using the laminated material, are provided. A manufacturing method of a laminated material for security tags characterized in that metal foils are laminated on both sides of a previously formed synthetic resin film, and security tags obtained by using the laminated material by the manufacturing method, are provided. Because the lamination is performed on the previously formed resin film, the amount of variation in thickness of the resin film is small, and the thin resin film can be preciselymanufactured. Further, because the oriented film has a relatively high strength even for a thin film, the laminated material is easy to be etched for forming a circuit. The security tag obtained by using a previously formed resin film can satisfy both uniformizing the resonance frequency and miniaturizing the security tag simultaneously, and has an excellent performance.

## Description

The present invention relates to a method of manufacturing a laminated material for security tags used for electronic article security systems, inventory management systems, and identifying, managing and tracing the chain-of-custody of articles and the like and a security tag using the same.

Security tags using a resonance circuit have been conventionally utilized for electronic article security system (for example, Japanese Patent Laid-Open No. 7-93671). A security tag is composed of a capacitor formed of electrodes on both sides of a dielectric film of organic compound such as polyethylene, polypropylene, etc., and a coil formed on one side or both sides of the dielectric film. Security tags are generally attached to articles, and resonate with an electromagnetic wave of the specific resonance frequency when it passes through a detecting device installed at the exit of a store, etc. The detecting device senses the absorption of the electromagnetic wave caused by the resonance, and raises the alarm. In the case where an article is taken out via normal procedures such as purchasing, the security tag is deactivated generally by dielectric breakdown of the dielectric film by a dedicated device and changing the resonance frequency so that the detecting device cannot raise the alarm. Recently an IC mounting security tag has been utilized as the RFID for identificating, managing and tracing the chain-of-custody, wherein a signal peculiar and unique to an article to which the security tag is attached is stored in the IC.

It is preferable that such security tags have the uniform resonance frequency and are miniaturized because they are usually attached to articles. More miniaturized security tags than conventional ones are demanded in the applications to, especially, precision devices such as watches, memory cards and mobile phones, and small expensive goods such as jewels and cosmetics.

For fabricating a security tag, a method in which a desired circuit pattern is formed by etching or other processes on a laminated material in which metal foils are laminated on both sides of an dielectric film is generally employed. The conventional laminated material is generally manufactured by the extrusion-lamination method where a dielectric organic compound such as polyethylene is extruded into a film while metal foils are simultaneously laminated thereon. However, when the lamination is performed simultaneously with the extrusion, the thickness of extruded dielectric film is hard to control and varies widely, and it is thus difficult to satisfy both uniformizing the resonance frequency and miniaturizing the security tag simultaneously.

It is an object of the present invention to provide a laminated material suitable for fabricating security tags that have the uniform resonance frequency. It is another object of the present invention to provide a laminated material suitable for fabricating miniaturized security tags. It is a further object of the present invention to provide securitytags obtained by using such laminated material.

The above described objects of the present invention are achieved by a method of manufacturing a laminated material for security tags characterized in that metal foils are laminated on both sides of a previously formed synthetic resin film by using or without using an adhesive; and by a security tag made from the laminated material thus obtained by the manufacturing method.

In the method according to the present invention, since the forming of a resin film and the lamination of metal foils are not simultaneously performed, as is the case with the extrusion-lamination, but the lamination is performed on the previously formed resin film, variation in the thickness of the resin film is reduced, and a thin resin film can be formed with high precision. A resin film having a thickness of, for example, 15 *µ*m or less, particularly 10 µm or less can be manufactured with high precision. An oriented synthetic resin film and a laminated material thus obtained have a relatively high strength even when they are thin and are easy to be etched for forming a circuit on the laminated material. The security tag obtained by using these materials can satisfy both uniformizing the resonance frequency and miniaturizing the security tag simultaneously, and have an excellent performance.

A metal foil used for the present invention is a silver foil, a copper foil, an aluminum foil or the like. Its thickness does not have any particular limitation, and a metal foil of, for example, 2 to 200 µm in thickness can be used. A silver foil, a copper foil or an aluminum foil used as the metal foil has a low electric resistance, so the circuit line width of the coil can be made narrow, whereby a security tag is favorably much more miniaturizable. On the other hand, using a lead foil as the metal foil is favorable because the flexibility of the security tag is improved. Using a tin foil, a nickel silver foil or a stainless steel foil as the metal foil is favorable because the corrosion resistance and durability are improved.

In the present invention, a synthetic resin film is formed previously, and then metal foils are laminated thereon by using or without using an adhesive.

A film of any synthetic resin can be used, as long as it has a dielectric constant suitable for a security tag. Polyethylene, polypropylene, polyester, polyamide, polyimide, cyclic olefin copolymer and polystyrene are exemplified. The dielectric constant of polyethylene is 2.26, and those of polyester, polyamide and polystyrene are 3 to 4, 3.3 and 2.54, respectively. Therefore, use of a synthetic resin film of the latter resins enables a large electrostatic capacity of the capacitor per unit area even in the same thickness as that of polyethylene, whereby the security tag is much more miniaturizable. The thickness of the synthetic resin film does not have any particular limitation, and the thickness is, for example, 1 to 100 µm. The synthetic resin film can be formed by a known method such as, the T-die method, the inflation method or the calendering-roll method. The oriented synthetic resin films have a relatively high strength even when they are thin, and a laminated material thus obtained is easy to be etched for forming a circuit on the laminated material. Therefore, oriented films are favorable.

In the present invention, when lamination is performed by using an adhesive, a conventionally used adhesive can be used, such as a urethane adhesive, an acrylic adhesive, a polyether-based adhesive, a polyester adhesive, an poly alkyl imine-based adhesive or a polyolefin adhesive. An alkyl titanate-based adhesive can also be used. Examples are as follows: DIC-DRY LX901 (base) and KW40 (polymerization catalyst), manufactured by DAINIPPON INK AND CHEMICALS, INC., as urethane adhesives;TM329(base)and CAT-8B(polymerization catalyst), manufactured by TOYO-MORTON, LTD., as polyether-based adhesives; VYLON 30SS (base), manufactured byTOYOBOCO., LTD., and CORONATE HL (polymerization catalyst), manufactured by NIPPON POLYURETHANE INDUSTRY CO., LTD., as polyester adhesives; EL-420, manufactured by TOYO-MORTON, LTD., as an poly alkyl imine based adhesive; CHEMIPEARL S300, manufactured by MITSUI CHEMICALS, INC., as a polyolefin adhesive; and KR2S, manufactured by AJINOMOTO CO., INC. , as an alkyltitanate-based adhesive. When lamination is performed by using an adhesive, metal foils and a resin film can be laminated by the so-called dry-lamination method or wet-lamination method, preferably the dry-lamination method. The dry-lamination method is a method in which a metal foil or a resin film or both are coated with the adhesive in advance and dried, and both of them are pressed while optionally heated.

When no adhesive is used, a laminated material can be manufactured by the heat-lamination method.

In adhering, each adhesive surface of metal foils or a resin film may be treated with a silane coupling agent, a titanate-coupling agent or an aluminum-coupling agent, prior to lamination.

The laminated material thus obtained according to the present invention can be made into a security tag by forming a desired circuit, for example, by etching. A circuit having an inductance coil and one capacitor electrode is formed on one side of the laminated material while a circuit having the other opposing capacitor electrode is formed on the other side to make into a security tag. Alternatively, a coil and an electrode may be formed oppositely on both sides of the laminated material, where the coil acts as a part of or the entire part of the capacitor.

The etching can be performed by known methods. A security tag can be fabricated, for example, by forming a circuit on the metal foil surface by the screen-printing using an etching resist ink and removing the part of the metal foil other than the circuit with an etchant. Alternatively, a resist circuit may be formed by curing the photoresist coating with ultraviolet irradiation or other means, and the etching may be performed.

The following examples illustrate the present invention, but do not limit the scope of the present invention.

### Example 1

An aluminum foil of 600 mm in width and 50 µm in thickness and a polypropylene film of 600 mm in width and 5 µm in thickness were dry-laminated by using a urethane adhesive, the used amount of which was 1 g/m². And the polypropylene film surface of the laminated material and another aluminum foil of 600 mm in width and 9 *µm* in thickness were then dry-laminated by using the urethane adhesive, the used amount of which was also 1 g/m², thus into a laminated material for security tags. A test specimen of 100 mm square was cut out from the left end, the mid part and the right end in the width direction of the laminatedmaterial, and then an electrostatic capacity between the two aluminum foils on both sides of the polypropylene film was measured for each test specimen. The difference between maximum and minimum values among the electrostatic capacities of the three specimens divided by the maximum value was used as the amount of variation.

### Comparative Example 1

An aluminum foil of 600 mm in width and 50 µm in thickness and an aluminum foil of 600 mm in width and 9 µm in thickness were laminated by the extrusion-lamination method of polyethylene into a laminated material for security tags, wherein the target thickness of the polyethylene film was 25 µm. As in Example 1, a test specimen of 100 mm square was cut out from the left end, the mid part and the right end in the width direction of the laminated material, and then an electrostatic capacity between the two aluminum foils on both sides of the polyethylene film was measured for each test specimen. The difference between maximum and minimum values among the electrostatic capacities of the three specimens divided by the maximum value was used as the amount of variation.

### Comparative Example 2

An aluminum foil of 600 mm in width and 50 µm in thickness and an aluminum foil of 600 mm in width and 9 µm in thickness were laminated by the extrusion-lamination method of polyethylene into a laminated material for security tags, wherein the target thickness of the polyethylene film was 13 µm. As in Example 1, a test specimen of 100 mm square was cut out from the left end, the mid part and the right end in the width direction of the laminated material, and then an electrostatic capacity between the two aluminum foils on both sides of the polyethylene film was measured for each test specimen. The difference between maximum and minimum values among the electrostatic capacities of the three specimens divided by the maximum value was used as the amount of variation.

**Table 1**

| | Electrostatic capacity (µF/m²) | | | Amount of variation in electrostatic capacities (%) |
|---|---|---|---|---|
| | Left end | Mid part | Right end | |
| Example 1 | 3.64 | 3.59 | 3.58 | 1.6 |
| Comparative Example 1 | 1.66 | 1.60 | 1.53 | 7.8 |
| Comparative Example 2 | 0.80 | 0.81 | 0.83 | 3.4 |

Although the values of electrostatic capacity in Example 1 are high enough exceeding 3.5 µF/m², the amount of variation is as low as 1.6%. Although the values of electrostatic capacity in Comparative Example 1 are less than 1.7 µF/m², which is less than half the 3.5 µF/m², the amount of variation is conversely as high as 7.8%, which provides the security tag from the laminated material with a large amount of variation in the resonance frequencies. In Comparative Example 2 where the amount of variation in electrostatic capacities is rendered relatively low through the conventional method, the values of electrostatic capacity are much lower, about 0.8 µF/m², whereby the security tag cannot be miniaturized.

The security tags of the present invention are attached to articles and can be designed to resonate with an electromagnetic wave of the specific frequency, and make a detecting device raise the alarm. Therefore, they are usable for preventing thefts in libraries and retail stores, etc. and identifying, managing and tracing the chain-of-custody of articles in circulation and for other purposes. Because the size of the security tags is miniaturizable, they are suitable especially for small articles.

## Claims

1. A method of manufacturing a laminated material for a security tag, comprising the step of laminating a metal foil on both sides of a synthetic resin film by using or without using an adhesive.

2. The manufacturing method according to claim 1, wherein the synthetic resin film is polyethylene, polypropylene, polyester, polyamide, polyimide, cyclic olefin copolymer or polystyrene.

3. The manufacturing method according to claim 1, wherein the adhesive is a urethane adhesive, an acrylic adhesive, a polyether-based adhesive, a polyester adhesive, an poly alkyl imine-based adhesive, a polyethylene adhesive, or an alkyl titanate-based adhesive.

4. The manufacturing method according to claim 1, wherein the metal foil is a silver foil, a copper foil, an aluminum foil, a lead foil, a nickel silver foil, or a stainless steel foil.

5. A security tag obtained by using a laminated material obtained by a manufacturing method according to any one of claims 1 to 4.
